# EUROPEAN PATENT APPLICATION

(11) **EP 2 391 193 A1**
(43) Date of publication of application: **30.11.2011**
(21) Application number: 10174606.3
(22) Date of filing: 31.08.2010
(51) Int. Cl.: H05K 5/02

(54) **Data storage device**

(30) Priority: 28.05.2010 TW 099117246
(71) Applicant: Walton Advanced Engineering Inc., Kaohsiung City 806 (TW)
(72) Inventor: Yu, Hong-Chi, 806, Kaohsiung City (TW)
(74) Representative: Ihle, Kornelia

(57) **Abstract**

A data storage device comprises a storage device and a carrier, allows the storage device's metal contacts and electronic device(s) to be respectively installed on a substrate's outer surface and inner surface, and embodies metal contacts on the storage device constantly and not perfectly or horizontally plugged into or unplugged from metal contacts in a USB jack connector of an electronic data exchange device by one user without a molding compound at rear ends of metal contacts deformed (or broken) or further poor contact between electronic device(s) and the substrate; on the other hand, a carrier linked to the storage device is manufactured in plastic, rubber, polymer, or pasteboard or a combination of these flexible materials hereinabove for the data storage device's various externals and a user's better holding.

## Description

### BACKGROUND OF THE INVENTION

### 1) FIELD OF THE INVENTION

The present invention relates to a data storage device, especially to a small, thin, and portable data storage device based on USB specifications.

### 2) DESCRIPTION OF THE PRIOR ART

Prosperous information and progressive technologies have embody more and more digital data stored in various storage devices, not the least of which are popular USB (Universal Serial Bus) devices with advantages such as handiness, portability, and plug-and-play.

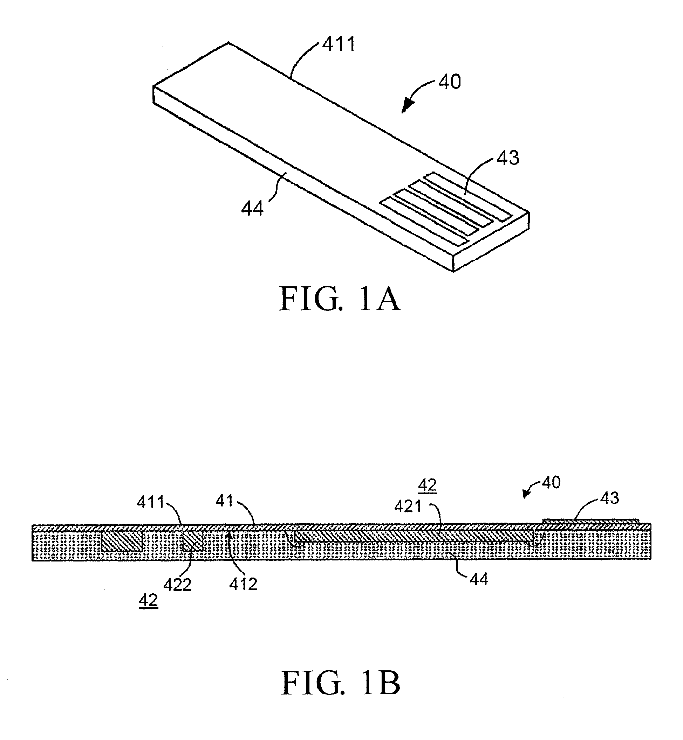

Referring to FIG. 1A and FIG. 1B which illustrate a USB device (40) manufactured in prior arts and comprising a substrate (41), a plurality of electronic devices (42), a plurality of metal contacts (43) matching USB data transfer interfaces, and a molding compound (44) wherein the metal contacts (43) are located on an outer surface (411) of a substrate (41) and the electronic devices (42) comprising a (or many) memory chip(s) (421) and a control chip (422) are installed on an inner surface (412) of the substrate (41) and electrically connected to the metal contact (43) to which the electronic devices (42) correspond.

Furthermore, an existing thin USB device (40) meets lightness, thinness, shortness, and smallness required in an existing electronic device.

However, it is hard for one user to perfectly keep the USB device (40) horizontally plugged into an electronic data exchange device such as one personal computer's slot. On the other hand, both a deformed or broken molding compound (44) at rear ends of metal contacts (43) and a deformed substrate (41) causing poor contact between electronic devices (42) and the substrate (41) or the electronic devices (42) easily damaged are usually observed at the existing constantly-plugged/unplugged USB device (40) with a thickness less than 2.0mm. Accordingly, an existing USB device (40) is easily damaged despite the USB device (40) satisfying an electronic device's requirements in lightness, thinness, shortness, and smallness.

Moreover, unfavorable to one user's holding, both solid molding compound surface and a thickness less than 2.0mm at an existing USB device (40) require a better solution.

### SUMMARY OF THE INVENTION

To solve those issues mentioned hereinabove, the principal object of the present invention is to provide a data storage device with its volume significantly curtailed and an installed electronic device partially corresponding to the metal contacts without an electronic device poorly contacted and damaged caused by a deformed substrate.

The additional object of the present invention is to provide a data storage device to which a carrier is connected for one user's better comfortable holding.

To reach the above purposes, the present invention is embodied with the following technical schemes. As one data storage device, the present invention comprises a storage device and a carrier wherein the storage device is provided with a substrate on which there is an inner surface and an outer surface with a plurality of metal contacts at one end electrically connected to not less than an electronic device on the inner surface and partially corresponding to the metal contacts, and the substrate's inner surface developing a molding compound encapsulating the electronic device; a carrier is connected to the storage device and makes the metal contacts exposed.

The purposes and the solved technical issues involved in the present invention are further embodied with the following measures.

The said data storage device has the metal contacts compatible to not less than one of the following data transfer interfaces such as Universal Serial Bus (USB), Mini Universal Serial Bus (Mini USB), Micro Universal Serial Bus (Micro USB), or External Serial Advanced Technology Attachment (e-SATA).

The said data storage device has the electronic device comprising a memory chip and a control chip at least.

The said data storage device has the carrier manufactured in plastic, rubber, polymer, or pasteboard or a combination of these flexible materials hereinabove.

The said data storage device has the storage device with a length less than 12.5mm and a width less than 11.5mm.

In contrast to the prior arts, the present invention is efficient in: (1) A storage device with a volume significantly curtailed and an installed electronic device partially corresponding to the metal contacts without a deformed substrate causing the electronic device poorly contacted or damaged; (2) A carrier linked to the storage device for one user's better and comfortable holding.

### BRIEF DESCRIPTIONS OF THE DRAWINGS

FIG. 1A is the perspective view of a USB device manufactured in prior arts.
FIG. 1B is the sectional view of the structure of a USB device manufactured in prior arts.
FIG. 2 is the sectional view of the structure for the present invention of a data storage device.
FIG. 3 is the perspective view of the storage device in the present invention of a data storage device.
FIG. 4 is the sectional view of the structure in the present invention of the data storage device and the USB jack connector.
FIG. 5 is the perspective view of the present invention of a data storage device.

### DETAILED DESCRIPTIONS OF THE PREFERRED

### EMBODIMENTS

For purposes, characteristics, and effects obviously and easily understood, the preferred embodiments of the present invention are particularly interpreted as follows:

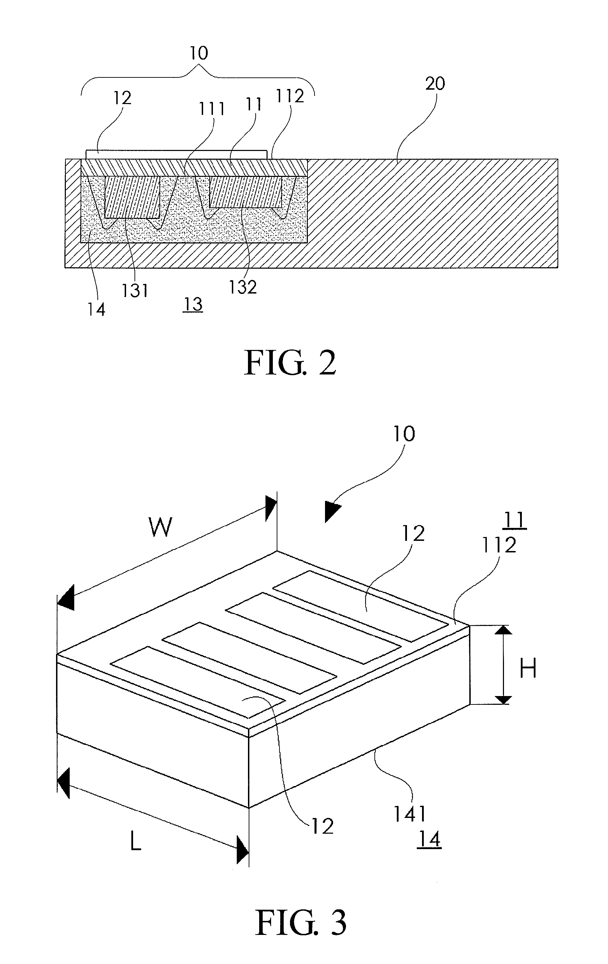

Referring to FIG. 2 and FIG. 3 which illustrate the principal embodiment of the present invention of a data storage device comprises a storage device (10) and a carrier (20). In this regard, the storage device (10) could be the package of a Chip-On-Board (COB) comprising a substrate (11) which has both an inner surface (111) with not less than an electronic device (13) and an outer surface (112) with a plurality of metal contacts (12) at one end wherein the substrate (11) is usually a high-density bidirectional-conducted multi-layer printed circuit board with circuits developed inside (not shown in two figures) and taken as electrical conduction interfaces for the electronic device (13) electrically connected to the metal contacts (12). The electronic devices (13) comprise a memory chip (131) and a control chip (132) at least which are electrically connected to the substrate (11) by a technology, either wire bonding or flip chip (not shown in two figures). The memory chip (131) could be a FLASH memory, a Static-Random-Access-Memory (SRAM), an Application-Specific-Integrated-Circuit (ASIC), or a Synchronous-Dynamic-Random-Access-Memory (SDRAM).

In practice, a molding compound (14) developed on the inner surface (111) of the substrate (11) is capable of encapsulating both a memory chip (131) and a control chip (132). In addition, passive devices (not shown in two figures) required in the storage device (10) are also installed on the inner surface (111) of the substrate (11) and sealed in the molding compound (14).

Furthermore, as shown in FIG. 2, the electronic device (13) lengthwise and partially corresponds to metal contacts (12). Referring to FIG. 3 which practically illustrates the storage device (10) with a length (L) less than 12.5mm and a width (W) less than 11.5mm, preferably the storage device (10) with a length (L) equal to 12.4mm and a width (W) equal to 11.3mm. In this regard, a height (H) between the outer surface (141) of the molding compound (14) and the outer surface (111) of the substrate (11) is less than 1.5mm, the most preferable height 1.4mm.

Preferably, the metal contacts (12) are compatible to not less than one of the following data transfer interfaces such as Universal Serial Bus (USB), Mini Universal Serial Bus (Mini USB), Micro Universal Serial Bus (Micro USB), or External Serial Advanced Technology Attachment (e-SATA). In this embodiment described herein, a plurality of metal contacts (12) are compatible to the data transfer interface of Universal Serial Bus (USB).

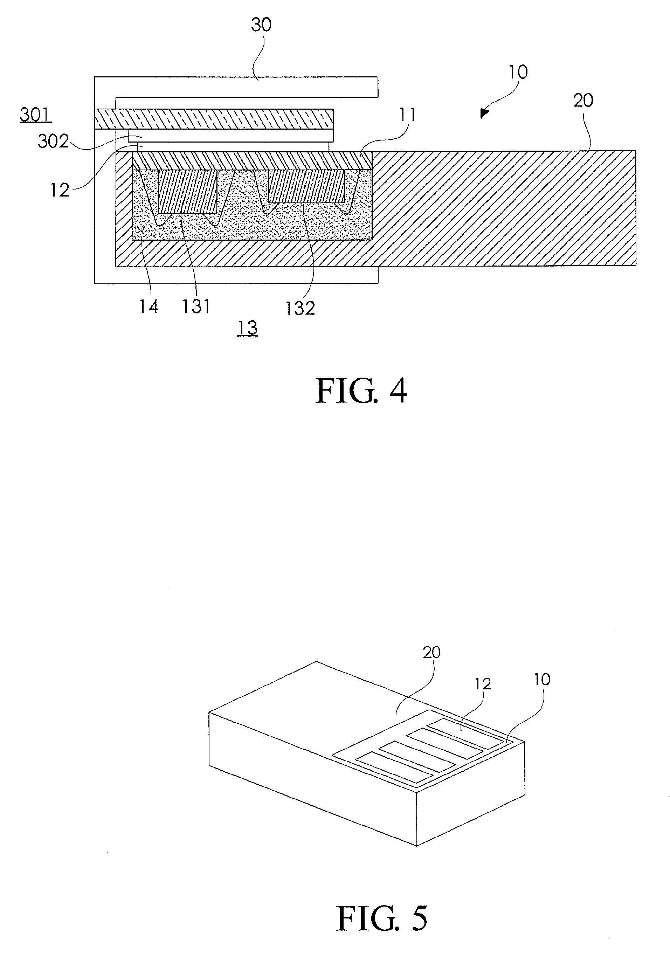

Referring to FIG.2 and FIG. 4 which illustrate the metal contacts (12) of the storage device (10) which are constantly and not kept perfectly or horizontally plugged into or unplugged from an electronic data exchange device, for instance, metal contacts (302) of a personal computer's USB jack connector (30), do not make a molding compound (14) at rear ends of the metal contacts (12) deformed or broken which lead to poor contact between the electronic device (13) and the substrate (11) or the electronic device (13) damaged.

Referring to FIG. 5 which illustrates a data storage device comprises and is connected to a carrier (20) and metal contacts (12) are exposed. Preferably, the carrier (20) practically manufactured in plastic, rubber, polymer, or pasteboard or a combination of these flexible materials hereinabove allows the data storage device to have various externals and an effectively curtailed weight triggering consumer sentiment and facilitating a user's better and comfortable holding. In addition, externals of the carrier (20) are not limited to the configuration of the embodiment and any change equivalent to the present invention does not depart from claims of the present invention.

With the above descriptions summarized, the present invention comprising a storage device and a carrier specifies: (1) The storage device's metal contacts and electronic device respectively installed on the outer surface and the inner surface of the substrate lengthwise correspond (that is, the electronic device partially corresponds to the metal contacts), and hence the present invention allows the metal contacts on the storage device to be constantly and non-horizontally plugged into or unplugged from metal contacts of an electronic data exchange device (for instance, a personal computer's USB jack connector) by one user without a molding compound at rear ends of the device's metal contacts deformed or broken, poor contact between the electronic device and the substrate, or the electronic device damaged; (2) The invention's carrier connected to the storage device is preferably manufactured in plastic, rubber, polymer, or pasteboard or a combination of the flexible materials hereinabove and embodies a data storage device with various externals and an effectively curtailed weight to trigger consumer sentiment and facilitate a user's better and comfortable holding. Consequentially, the present invention different from general conventional flash drives but regarded as creative work meets patentability and is applied for the patent.

The foregoing disclosure and description are illustrative and explanatory of preferred embodiments only and therefore any equivalent change in the instruction, claims, or drawings of the present invention does not depart from the scope of the present invention.

## Claims

1. A data storage device comprising:
A storage device (10) comprises a substrate (11) with an inner surface (111) and an outer surface (112) wherein the outer surface (112) has a plurality of metal contacts (12) at one end, the inner surface (111) is provided with not less than an electronic device (13), which is electrically connected to and partially corresponds to the metal contacts (12), and forms a molding compound (14) encapsulating the electronic device (13);
A carrier (20) is connected to the storage device (10) and allows the metal contact (12) to be exposed.

2. The data storage device according to Claim 1 wherein the metal contacts (12) are compatible to not less than one of the following data transfer interfaces such as Universal Serial Bus (USB), Mini Universal Serial Bus (Mini USB), Micro Universal Serial Bus (Micro USB), or External Serial Advanced Technology Attachment (e-SATA)

3. The data storage device according to Claim 1 wherein the electronic device (13) comprises a memory chip (131) and a control chip (132) at least.

4. The data storage device according to Claim 1 wherein the carrier (20) is manufactured in plastic, rubber, polymer, or pasteboard or a combination of the flexible materials hereinabove.

5. The data storage device according to Claim 1 wherein the storage device (10) has a length (L) less than 12.5mm and a width (W) less than 11.5mm.
